(19) **Europäisches Patentamt**
**European Patent Office**
**Office européen des brevets**

(11) **EP 2 293 440 A1**

(12) **EUROPÄISCHE PATENTANMELDUNG**

(43) Veröffentlichungstag:
**09.03.2011 Patentblatt 2011/10**

(51) Int Cl.:
***H03H 17/02*** *(2006.01)*

(21) Anmeldenummer: **09169736.7**

(22) Anmeldetag: **08.09.2009**

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(71) Anmelder: **Deuta-Werke GmbH**
**51465 Bergisch Gladbach (DE)**

(72) Erfinder: **Koch, Rainald**
**40699, Erkrath (DE)**

(74) Vertreter: **Lippert, Stachow & Partner**
**Patentanwälte**
**Postfach 30 02 08**
**51412 Bergisch Gladbach (DE)**

(54) **Verfahren zur Verarbeitung von zeitabhängigen, diskretisierten Messwerten durch einen Kalman-Filter**

(57) Es wird ein Verfahren zur interpolierenden und ausgleichenden Verarbeitung von zeitabhängig eintretenden Ereignissen der Übereinstimmung einer Messgröße mit diskreten Werten mittels eines Filters, wobei jeweils bei Eintreten eines Ereignisses ein Update des Zustandes des Filters durchgeführt wird beschrieben, wobei beim Ausbleiben von Ereignissen ein fiktiver Messwert zwischen den beiden als nächste möglichen diskreten Werten für ein Pseudo-Update des Filters eingesetzt wird.

**EP 2 293 440 A1**

**Beschreibung**

Die vorliegende Erfindung betrifft ein Verfahren zur interpolierenden und ausgleichenden Auswertung von zeitabhängig eintretenden Ereignissen der Übereinstimmung einer kontinuierlichen Messgröße mit diskreten Werten mittels eines Kalman-Filters.

Die Information über das Ereignis besteht in der Kombination eines gemessenen Zeitpunktes und dem getroffenen diskreten Wert. Letzterer wird im Folgenden Phasenmesswert genannt, denn vorzugsweise sind die diskreten Werte äquidistant und entsprechen festen Phasenwinkeln eines periodischen Prozesses. Falls die diskreten Werte nicht äquidistant sind, müssen sie doch im Voraus bekannt oder berechenbar sein. Falls die Phase des Prozesses oder Systems nicht stets monoton zunimmt, müssen ggf. abweichende diskrete Werte in Rückwärtsrichtung ebenfalls bekannt sein.

Insbesondere betrifft die Erfindung ein Verfahren zur Messung der Phase und Ermittlung entweder nur der Frequenz oder auch ihrer Änderungsrate jeweils als zeitabhängige Verläufe.

Es ist beispielsweise bekannt, Zählimpulse zur Weg-, Geschwindigkeits- oder auch Beschleunigungsbestimmung von Fahrzeugen mittels einer mit dem Rad des Fahrzeugs in fester Rotationskorrelation stehenden Sektorscheibe und einem helle bzw. lichtdurchlässige und dunkle bzw. lichtundurchlässige Sektoren der Scheibe unterscheidenden, am Fahrzeug ortsfesten Detektor zu erzeugen (Winkelencoder), wobei Zählimpulse nach Kalibrierung dem zurückgelegten Weg entsprechen.

Diese Impulse werden auf einen Impulszähler gegeben, wobei in vorgegebenen periodischen Zeitabständen das Zählerinkrement auf einen Kalman-Filter gegeben wird zur Korrektur ("Update") des prädizierten Systemzustandes samt Fehlerkovarianzmatrix.

Es ist weiterhin bekannt, die zeitliche Länge der Prädiktionsschritte des Kalman-Filters einzeln so zu wählen, dass die Updates dann stattfinden, wenn die Phase möglichst exakt bekannt ist, nämlich zu mit angemessener Auflösung bestimmten Zeitpunkten der Ereignisse "Zählimpuls".

Falls das übergeordnete System zu anderen Zeitpunkten über den Zustand des modellierten Systems informiert werden soll, muss interpoliert werden. Die Interpolation zwischen den zu den Impulsen synchronen Updates ist unproblematisch, solange schneller Impulse hereinkommen als die Phase im Systemmodell deutlich unscharf wird. Im Extremfall bleiben aber Impulse, und damit Updates, völlig aus, so dass die fortgesetzte Propagation des Systemmodells zu an das übergeordnete System gemeldeten Vorhersagen für Phase und Frequenz führt, die mit dem Ausbleiben von Impulsen nicht verträglich, d.h. inkonsistent sind.

Eine gesonderte Stillstandserkennung ist möglich, wird aber mit heuristisch festgelegten Schwellen z.B. für die Frequenz realisiert. Jedenfalls muss der Zustand des Kalman-Filters manipuliert werden, damit er nicht inkonsistent wird, spätestens durch Neuinitialisierung sobald wieder Impulse eintreffen.

Bei schwankenden niedrigen Frequenzen (Beispiele sind Signale von Radsensoren beim traktionskontrollierten Anfahren auf Schnee oder von einem Sensor an der Welle eines stotternden Motors oder eines in turbulenter Strömung rotierenden Körpers, aber auch eine interferometrisch bestimmte optische oder akustische Weglänge) wird der Kalman-Filter dem übergeordneten System oft Wahrscheinlichkeitsverteilungen für die Phase präsentieren, die zu einem beträchtlichen Teil jenseits des nächsten Impulses liegen. In diesen Meldungen die Information des Ausbleibens des Impulses nicht zu berücksichtigen, ist Stand der Technik und mag (abhängig vom Anwendungsfall) für die Phase unerheblich sein, aber eher nicht für die Frequenz- und Beschleunigungskomponente.

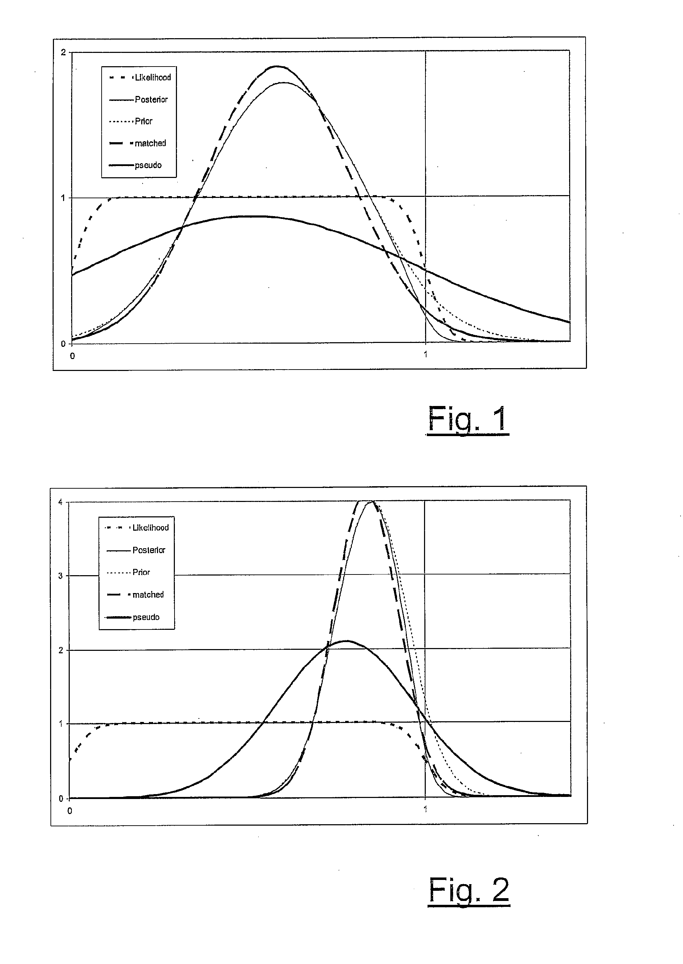

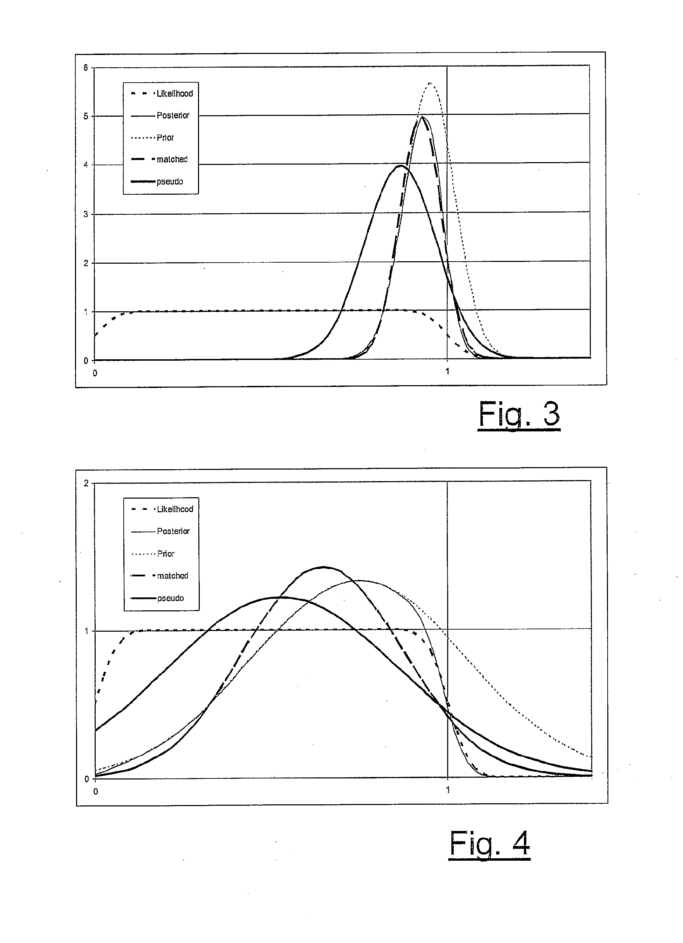

Fig. 1 bis 4 zeigen beispielhaft einige charakteristische Fälle von konsistenten (Fig. 1 und 2) und inkonsistenten Vorhersagen (Fig. 3 und 4) als gaußförmige Wahrscheinlichkeitsdichten der Phase (Ordinate). Die auf der Abszisse abgetragene Phase ist ohne Beschränkung der Allgemeinheit so skaliert, dass die Phasenwerte 0 und 1 den beiden möglichen nächsten diskreten Phasenwerten entsprechen, gegen bzw. in die prädizierte Bewegungsrichtung.

Die Kurve "Prior" ist die vom Filter prädizierte Wahrscheinlichkeitsverteilung (für allein die Phase) nach der Propagation des Filterzustands auf das Ende der Protokollperiode $\tau$. Vorzugsweise wird nur zu diesen Zeitpunkten auf Inkonsistenz der Vorhersage geprüft.

Die Information "kein weiteres Ereignis" würde idealerweise durch Abschneiden des Priors an den Intervallgrenzen berücksichtigt. Das geschieht durch Multiplikation des Priors mit der Kurve "Likelihood". Das Ergebnis dieser Multiplikation ist die "Posterior"-Verteilung (in der Darstellung noch nicht normiert). Dass das Abschneiden nicht vertikal, sondern unscharf geschehen sollte, liegt an der Unsicherheit der Phasenmessung, ggf. auch der Zeitmessung.

In Fig. 1 ist der Korrektureffekt von "Prior" zu "Posterior" klein, weil schon die Vorhersage nahezu in die Mitte des Phasenintervalls fällt. Ein Pseudo-Update ist nicht angezeigt.

In Fig. 2 liegt die Vorhersage dichter am Phasenmesswert, ist dafür aber schmaler, so dass ebenfalls nur ein kleiner Teil der unter der Kurve liegenden Fläche jenseits des Phasenwertes 1 liegt. Wieder ist ein Pseudo-Update nicht angezeigt.

In den Fig. 3 und 4 unterscheiden sich "Prior"- und "Posterior"-Verteilung deutlich. Ein Pseudo-Update ist angezeigt (das angemessene Kriterium ist der Anteil der außerhalb des Intervalls [0, 1] liegenden Fläche unter der Posterior-Verteilung, angemessene Schwellen liegen zwischen 20 und 40 Prozent).

Die "Posterior"-Verteilung ist nicht gaußförmig und daher mit Kalman-Filtern nicht realisierbar. Ersatzweise soll die gaußförmige Verteilung des Kalman-Filters (für die Phase) wenigstens den gleichen Mittelwert und die gleiche Varianz annehmen wie die Posterior-Verteilung (Moment-Matching, Kurve "matched", noch nicht normiert).

Statt nun die Komponenten des Filterzustands (d.h. die Komponenten des Vektors **x** und der Matrix **P,** siehe unten) einzeln zu manipulieren, was die Gefahr von Inkonsistenzen birgt, wird erfindungsgemäß ein sogenanntes Pseudo-Update des Kalman-Filters durchgeführt mit einem geeignet gewählten, fiktiven Messwert mit geeigneter Varianz.

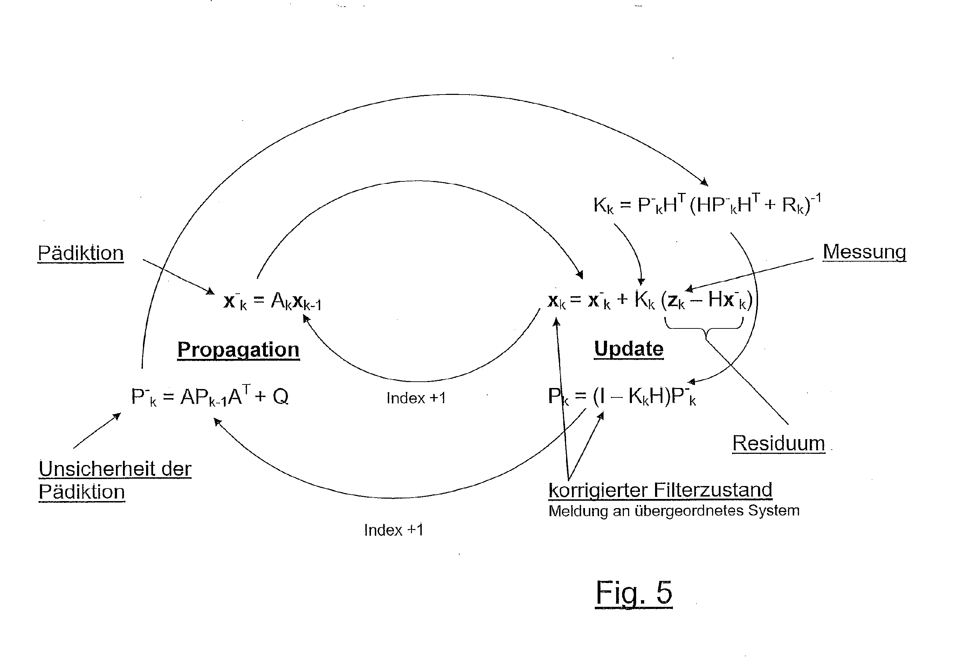

Die bekannten Formeln für den Kalman-Gain **K** (siehe unten Fig. 5) laufen darauf hinaus, dass sich die upgedatete Phase s (mit Varianz $p_{ss}$) als gewichteter Mittelwert aus der Prior-Phase $s^-$ und dem Messwert z ergibt, wobei die Gewichte die Kehrwerte der Varianzen sind, also $1/p_{ss}^-$ bzw. $1/r$. Diese Formeln der gaußschen Fehlerfortpflanzung lassen sich einfach nach z und r auflösen:

$$r = 1/(1/p_{ss} - 1/p_{ss}^-)$$

$$z = r \cdot (s/p_{ss} - s^-/p_{ss}^-)$$

Für die Auswertung dieser Formeln sind aber zunächst s und $p_{ss}$ als Mittelwert und Varianz der nicht gaußförmigen Posterior-Verteilung z.B. durch numerische Integration ermitteln. Dies wird zweckmäßigerweise nicht zur Laufzeit des Filters erfolgen, sondern vorher - und die Ergebnisse werden dann geeignet parametrisiert.

Dabei ist zu berücksichtigen, dass ein Pseudo-Update mit r als Varianz des fiktiven Phasenmesswertes ein unnötig harter Eingriff in den Filterzustand wäre, falls schon dadurch bei kurzen Protokollperioden $\tau$ der nächste Test auf Inkonsistenz negativ ausfallen würde. Erfindungsgemäß wird deshalb ggf. die Wirkung des Pseudo-Updates vermindert, indem r um einen Faktor vergrößert wird (s.u.).

Eine etwas aufwändige Variante der Parametrisierung benutzt tabellierte Werte sowohl für die Entscheidung über die Durchführung des Pseudo-Updates als auch für die ggf. benötigten Parameter r und z des fiktiven Messwertes. Die Vorausberechnung geschieht als Funktion von $s^-$ und $p_{ss}^-$ und berücksichtigt die vorher festzulegenden Filterparameter $\tau$, q und die Varianz der regulären Phasenmesswerte. Die Tabelle wird in einem genügend schnell lesbaren Speichermedium abgelegt und zur Laufzeit mit gerundeten Werten von $s^-$ und $p_{ss}^-$ adressiert.

Alternativ werden die Ergebnisse der Wahrscheinlichkeitsrechnung durch Näherungsformeln parametrisiert.

Dafür gibt es viele Möglichkeiten, die zwar unnötig grob sind, aber in ihrer Wirkung dennoch einen Fortschritt gegenüber dem Stand der Technik darstellen. Eine solche Ausführungsform ist deshalb stellvertretend für ähnlich grobe Näherungen oder heuristisch gefundene Formeln als Anspruch 8 bis 10 formuliert.

Die bevorzugte Ausführungsform der Erfindung: Eine ein Pseudo-Update auslösende Inkonsistenz ist gegeben, wenn $s^- + n\sqrt{p_{ss}^-}$ oder $s^- - n\sqrt{p_{ss}^-}$ außerhalb des aktuellen Intervalls der beiden als nächstes möglichen diskreten Phasenwerte in positiver bzw. negativer Richtung ([0, 1] in Fig. 1 bis 4) liegen, wobei n ein vorbestimmter Wert zwischen 0,6 und 1,4, vorzugsweise etwa 1, ist. Dabei werden bevorzugt sowohl Phasenwert als auch Varianz für das Pseudo-Update aus einem linken und einem rechten Wert abgeleitet: Der linke ist das Maximum der linken Intervallgrenze (0) und $s^- - m\sqrt{p_{ss}^-}$, der rechte das Minimum der rechten Intervallgrenze (1) und $s^- + m\sqrt{p_{ss}^-}$, wobei m ein vorbestimmter Wert zwischen 1,5 und 2,5 ist. Der zu benutzende Phasenwert ist die Mitte dieser beiden Werte, die Varianz das Produkt ihrer quadrierten halben Differenz mit dem Maximum von 1 und dem Verhältnis aus der Zeitdauer, in der $\sqrt{p_{ss}^-}$ durch Propagation mit dem Parameter q von Null auf 0,5 steigt, und der Protokollperiode $\tau$.

Die Formulierung eines Kalman-Filters (nach dem Stand der Technik, ohne Steuerungsinformation) ist in Fig. 5 dargestellt:

Der Filterzustand wird durch den Zustandsvektor **x** und dessen Kovarianzmatrix **P** beschrieben. Propagierte Filterzustände sind mit einem hochgestellten "-"-Zeichen versehen. Der Index k bezeichnet die Folge der Filterzyklen und wird jeweils vor der Propagation hochgezählt. Er dient lediglich der sauberen mathematischen Beschreibung und kommt in der Implementation des Filters nicht vor.

Beispielhaft wird Fig. 5 anhand eines für die Erfindung typischen dreidimensionalen Modells erläutert: Die der Phase entsprechende Komponente des Filterzustands ist, weil sie nach Kalibrierung vielleicht einem Weg entspricht, mit s bezeichnet, abgeleitete Größen sind die Frequenz (alias Geschwindigkeit) v und die Beschleunigung a. Diese drei Variablen sind zum Zustandsvektor

$$\mathbf{X}_k = \begin{pmatrix} s \\ v \\ a \end{pmatrix}_k$$

zusammengefasst dessen Unsicherheit nach jedem Rechnungsschritt durch die Kovarianzmatrix

$$\mathbf{P}_k = \begin{pmatrix} p_{ss} & p_{sv} & p_{sa} \\ p_{sv} & p_{vv} & p_{va} \\ p_{sa} & p_{va} & p_{aa} \end{pmatrix}_k$$

beschrieben wird.

Die Propagation ist die Fortschreibung des Filterzustandes gemäß einem Modell für die Dynamik des Systems, beschrieben durch die Matrix **A,** hier

$$\mathbf{A}_k = \begin{pmatrix} 1 & \Delta t_k & 0{,}5\Delta t_k^2 \\ 0 & 1 & \Delta t_k \\ 0 & 0 & 1 \end{pmatrix}.$$

Der nächste Zeitpunkt $t_k$ für die Berechnung der Propagationslänge $\Delta t_k = t_k - t_{k-1}$ ist erfindungsgemäß abwechselnd der Zeitpunkt des innerhalb der Protokollperiode aufgetretenen Ereignisses (Zählimpulses) bzw. das Ende der Protokollperiode. Ergebnis der Propagation ist einerseits der für $t = t_k$ erwartete (vorhergesagte, prädizierte) Zustand $\mathbf{x}^-_k = \mathbf{A}_k\mathbf{x}_{k-1}$ sowie die Kovarianzmatrix $\mathbf{P}^-_k = \mathbf{A}_k\mathbf{P}_{k-1}\mathbf{A}_k^\top + \mathbf{Q}_k$, welche die Unsicherheit der Vorhersage beschreibt. $\mathbf{Q}_k$ ist dabei der regelmäßig empirisch bestimmte Systemfehler. Im vorliegenden Beispiel wird mit

$$\mathbf{Q}_k = \begin{pmatrix} 0 & 0 & 0 \\ 0 & 0 & 0 \\ 0 & 0 & q\Delta t_k \end{pmatrix}$$

berücksichtigt, dass die Beschleunigung, anders als durch das gewählte **A** modelliert, doch nicht konstant sein wird.

Die rechte Seite von Fig. 5 beschreibt die Korrektur des Filterzustands durch Einspeisen des (tatsächlichen oder fiktiven) Messwertes $Z_k$.

Darin wird die Differenz $z_k - \mathbf{H}\mathbf{x}^-_k$ des aktuellen Messwertes zum vorhergesagten Messwert als Residuum bezeichnet, hier mit der Messmatrix $\mathbf{H} = (1\ 0\ 0)$ also $\mathbf{H}\mathbf{x} = s$.

Die Korrektur von $\mathbf{x}^-_k$ und $\mathbf{P}^-_k$ erfolgt mit dem von der Varianz $\mathbf{R}_k = [r_k]$ der Messwerte abhängenden, matrixwertigen Kalman-Gain, wobei $r_k$ entweder die regelmäßig experimentell bestimmte Varianz der Phasenmesswerte ist, z.B. r = 0,01, oder die deutlich größere Varianz eines fiktiven Messwertes, z.B. 0,4.

Typischerweise gibt es nur zu jedem zweiten k ein Update, weil entweder (bei hoher Geschwindigkeit) keine Pseudo-Updates nötig sind oder (bei kleiner Geschwindigkeit) oft kein Ereignis aufgetreten ist. In letzterem Fall können die beiden Propagationsschritte zu einem einzigen der Länge $\Delta t = \tau$ zusammengefasst werden. Das Auslassen eines Pseudo-Updates kann durch Nullsetzen des Kalman-Gains bewirkt werden, was auf $\mathbf{x}_k = \mathbf{x}^-_{k-1}$ und $\mathbf{P}_k = \mathbf{P}^-_{k-1}$ hinausläuft. Der ggf. korrigierte Zustandsvektor $\mathbf{x}_k$ bzw. $\mathbf{x}^-_k$ wird an das übergeordnete System gemeldet und dort verarbeitet.

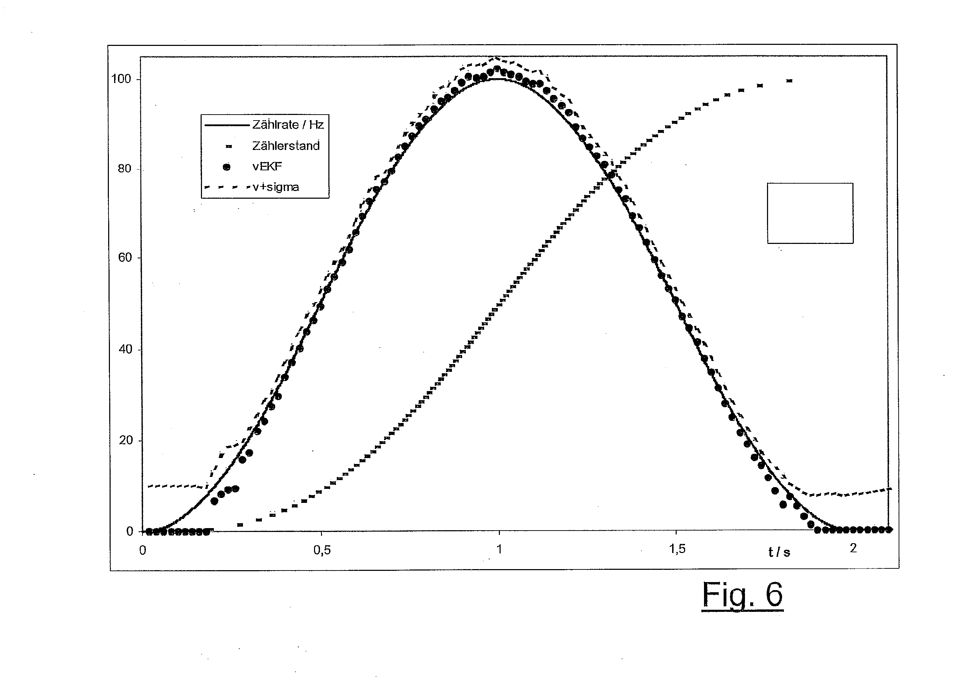

Fig. 6 zeigt das Beispiel des mit dem erfindungsgemäßen Kalman-Filter ermittelten zeitlichen Verlaufs der Geschwindigkeitskomponente des Filterzustands, wie sie je Protokollperiode $\tau$ ausgegeben wird, bezeichnet als vEKF (dicke Punkte), in Abhängigkeit von simulierten, mit variierender Rate eintreffenden Zählimpulsen (horizontale kurze Striche charakterisieren den jeweiligen Zählerstand unmittelbar nach einem Zählimpuls) sowie der jeweiligen Varianz der Geschwindigkeit (quadrierter Abstand der Kurve v+sigma von vEKF). Parameter: $\tau$ = 0,02 s, r = 0,01, q = 300. Auf die Darstellung der Beschleunigung a wurde in Fig. 6 aus Gründen der Übersichtlichkeit verzichtet.

**Patentansprüche**

1. Verfahren zur interpolierenden und ausgleichenden Verarbeitung von zeitabhängig eintretenden Ereignissen der Übereinstimmung einer Messgröße mit diskreten Werten mittels eines Filters, wobei jeweils bei Eintreten eines Ereignisses ein Update des Zustandes des Filters durchgeführt wird, **dadurch gekennzeichnet, dass** bei Ausbleiben von Ereignissen ein fiktiver Messwert zwischen den beiden als nächste möglichen diskreten Werten für ein Pseudo-Update des Filters eingesetzt wird.

2. Verfahren nach Anspruch 1, **dadurch gekennzeichnet, dass** das Filter ein Kalman-Filter ist, das anhand eines vorgegebenen Systemmodells abgeleitete Größen bildet und bereitstellt.

3. Verfahren nach einem der vorstehenden Ansprüche, **dadurch gekennzeichnet, dass** ein Pseudo-Update erst dann durchgeführt wird, wenn die vom Filter vorhergesagte Wahrscheinlichkeitsverteilung für den Messwert beträchtlich außerhalb des von den nächstmöglichen Werten begrenzten Intervalls liegt, mit einem Schwellwert für "beträchtlich" von vorzugsweise 20 bis 40 Prozent der kumulierten Wahrscheinlichkeit.

4. Verfahren nach einem der vorstehenden Ansprüche, **dadurch gekennzeichnet, dass** der Wert und die Varianz des fiktiven Messwertes so gewählt werden, dass die Wahrscheinlichkeitsverteilung des Filters für die Phase nach dem Pseudo-Update dieselben Momente (Mittelwert und Varianz) hat wie die Posterior-Verteilung, die sich aus der Multiplikation der Verteilung vor dem Update mit der Likelihood-Verteilung ergibt, die im Rahmen der Messgenauigkeit der Phase dem aktuellen Intervall zwischen den beiden als nächste möglichen diskreten Werten entspricht.

5. Verfahren nach einem der vorstehenden Ansprüche, **dadurch gekennzeichnet, dass** ein berechneter fiktiver Messwert durch Skalieren seiner Varianz in seiner Wirkung auf den Filterzustand abgeschwächt wird, falls sonst der nächste Test auf Inkonsistenz negativ ausfallen würde.

6. Verfahren nach Anspruch 4, **dadurch gekennzeichnet, dass** Ergebnisse vor der Laufzeit des Filters vorausberechnet und tabelliert und zur Laufzeit aus einem schnellen Speicher ausgelesen werden.

7. Verfahren nach Anspruch 4, **dadurch gekennzeichnet, dass** Ergebnisse zur Laufzeit durch einfache Ausdrücke näherungsweise berechnet werden.

8. Verfahren nach Anspruch 7, **dadurch gekennzeichnet, dass** das Pseudo-Update ausgelöst wird, wenn - jeweils bezogen auf den für die Anwendung typischen Abstand benachbarter diskreter Werte - die Differenz aus dem Vorhersagewert $s^-$ und dem in der aktuellen Bewegungsrichtung nächsten erwarteten diskreten Wert größer als ein vorbestimmter Wert zwischen -0,2 und 0,5, besonders bevorzugt zwischen -0,1 und 0,1, <u>oder</u> die Unsicherheit $"\sqrt{p_{ss}^-}$ der Vorhersage größer als ein vorbestimmter Wert zwischen 0,4 und 1 ist.

9. Verfahren nach Anspruch 7, **dadurch gekennzeichnet, dass** als fiktiver Messwert für das Pseudo-Update ein Wert benutzt wird, der ein Viertel bis drei Fünftel des für die Anwendung typischen Abstands benachbarter diskreter Werte vor dem erwarteten nächsten diskreten Phasenwert liegt ("vor" bedeutet hier: entgegen der durch das Vorzeichen von $v^-$ implizierten aktuellen Bewegungsrichtung).

10. Verfahren nach Anspruch 7, **dadurch gekennzeichnet, dass** als Varianz für den fiktiven Messwert ein Wert benutzt wird, der etwa ein Viertel des Quadrats des besagten typischen Abstands beträgt, ggf. gemäß Anspruch 5 vergrößert.

11. Verfahren nach Anspruch 7, **dadurch gekennzeichnet, dass** ein Pseudo-Update ausgelöst wird, wenn $s^- + n\sqrt{p_{ss}^-}$ oder $s^- - n\sqrt{p_{ss}^-}$ außerhalb des aktuellen Intervalls der beiden als nächstes möglichen diskreten Phasenwerte liegen, wobei n ein vorbestimmter Wert zwischen 0,6 und 1,4, vorzugsweise etwa 1, ist.

12. Verfahren nach Anspruch 7, **dadurch gekennzeichnet, dass** der Phasenwert für das Pseudo-Update als Mittelwert bzw. die Varianz aus der Differenz eines linken und eines rechten Wertes abgeleitet werden, wobei der linke das Maximum der linken Intervallgrenze und $s^- - m\sqrt{p_{ss}^-}$ ist, der rechte das Minimum der rechten Intervallgrenze und $s^-$

+ $m\sqrt{p_{ss}^-}$, mit einem vorbestimmten Wert m zwischen 1,5 und 2,5.

**13.** Verfahren nach einem der vorstehenden Ansprüche, **dadurch gekennzeichnet, dass** nicht alle der innerhalb einer vorbestimmten Protokollperiode $\tau$ eintretenden Ereignisse für ein Update des Filters herangezogen werden, vorzugsweise nur das letzte.

**14.** Verfahren nach einem der vorstehenden Ansprüche, **dadurch gekennzeichnet, dass** die Ereignisse von einem mit einer drehenden Welle in Rotationskorrelation stehenden Winkelencoder resultieren.

**15.** Verfahren nach Anspruch 14, **dadurch gekennzeichnet, dass** die drehende Welle die Achse des Rades eines Fahrzeugs ist und die abgeleiteten Größen nach Kalibrierung Weg, Geschwindigkeit und/oder Beschleunigung des Fahrzeugs sind.

**Fig. 1**

**Fig. 2**

Fig. 3

Fig. 4

8

EP 2 293 440 A1

Pädiktion

$$\mathbf{x}^-_k = A_k\mathbf{x}_{k-1}$$

**Propagation**

$$P^-_k = AP_{k-1}A^\top + Q$$

Unsicherheit der Pädiktion

$$K_k = P^-_kH^\top (HP^-_kH^\top + R_k)^{-1}$$

Messung

$$\mathbf{x}_k = \mathbf{x}^-_k + K_k (\mathbf{z}_k - H\mathbf{x}^-_k)$$

**Update**

$$P_k = (I - K_kH)P^-_k$$

Residuum

Index +1

korrigierter Filterzustand
Meldung an übergeordnetes System

Index +1

Fig. 5

Fig. 6

| Europäisches Patentamt European Patent Office Office européen des brevets | **ERKLÄRUNG** die nach Regel 63 des Europäischen Patentübereinkommens für das weitere Verfahren als europäischer Recherchenbericht gilt | **Nummer der Anmeldung** EP 09 16 9736 |

| Die Recherchenabteilung ist der Auffassung, daß die vorliegende Patentanmeldung den Vorschriften des EPÜ in einem solchen Umfang nicht entspricht, daß sinnvolle Ermittlungen über den Stand der Technik auf der Grundlage aller Patentansprüche nicht möglich sind. | **KLASSIFIKATION DER ANMELDUNG (IPC)** |
|---|---|
| Grund: | INV. H03H17/02 |

Die Ansprüche 1-15 sind so unklar dass eine sinvolle Recherche derselben unmöglich ist. Die Gründe sind folgende: Der charakterisierenden Teil des Anspruchs 1 enthält folgende Merkmale:a) Bei Ausbleiben von Ereignissen (d.h dass keine eintretende diskrete Werte zur Verfügung stehen), ein fiktiver Messwert zwischen den beiden als nächste möglichen diskreten Wertenb) für ein Pseudo-Update des Filters eingesetzt wird.Der Begriff "Pseudo-Update" ist, für sich genommen, unklar. Darüber hinaus wird in dem Anspruch nicht ausgelegt, wie "Update" zu verstehen ist, folglich kann die Bedeutung des Begriffs "Pseudo-Update" aus dem Anspruch nicht abgeleitet werden.Die Beziehung zwischen "interpolierenden und ausgleichenden Verarbeitung" und das "Pseudo-Update" ist aus folgenden Gründen nicht deutlich:Eine Analyse der Merkmale (a, b) deutet an, dass die "Einsetzung eines fiktiver Messwerts zwischen den beiden als nächste möglichen diskreten Werte" der "interpolierenden Verarbeitung" entspricht. Was nicht verstanden werden kann, ist in welchem Sinn diese "Einsetzung eines fiktiver Messwerts" "für ein Pseudo-Update des Filters" gilt. Folglich ist Anspruch 1 unklar.Da der Anspruch 1 unklar ist, werden restliche Ansprüche 2-15, welche vom Anspruch 1 abhängig sind, dementsprechend unklar.Aus der oben angeführten Erörterterung erfolgt eine Unklarheit im Sinne des Artikels 84 EPÜ dermassen, dass eine sinvolle Recherche der Ansprüche 1-15 unmöglich ist.Eine Recherche eindeutiger beschriebenen Ausführungsforme ist aus

-/--

| Recherchenort | Abschlußdatum | Prüfer |
|---|---|---|
| Den Haag | 25. Januar 2010 | De La Pinta, Luis |

EPO FORM 1504 (P04F39)

Europäisches Patentamt

European Patent Office

Office européen des brevets

**ERKLÄRUNG**

die nach Regel 63 des Europäischen Patentübereinkommens für das weitere Verfahren als
europäischer Recherchenbericht gilt

Nummer der Anmeldung

EP 09 16 9736

| Die Recherchenabteilung ist der Auffassung, daß die vorliegende Patentanmeldung den Vorschriften des EPÜ in einem solchen Umfang nicht entspricht, daß sinnvolle Ermittlungen über den Stand der Technik auf der Grundlage aller Patentansprüche nicht möglich sind. | KLASSIFIKATION DER ANMELDUNG (IPC) |
|---|---|
| Grund:<br><br>folgendem Grund unausführbar:Da das Kalman-Filter aus zwei Teilen: Prädiktion bzw. Korrektion besteht, wobei zu jeder Zeit ein "Update" nach der Korrektion der Prädiktion erfolgt, ist nicht deutlich, wie zwei "als nächste mögliche diskrete Werte" ermittelt werden können.In der Beschreibung wird auf der Seite 6, Z. 18-35 die einzige Ausfühungsform der Erfindung ("die bevorzugte Ausführungsform der Erfindung") angegeben. In der Darlegung der Ausführungsform wird auf die "beiden als nächste möglichen diskreten Phasenwerte" hingewiesen, ohne anzugeben wie jene zu bestimmen sind. Wie oben angeführt, ist nicht deutlich, wie das Kalman-Filter zwei "nächste mögliche" Werte berechnen kann. Es folgt, dass das Vorgehen der Einsetzung "eines fiktiven Messwert zwischen den beiden" aus der Beschreibung nicht verstanden werden kann. Daher ist auch das Vorgehen des "Pseudo-Update" unklar.Eine Abklärung der Ausführungsform der Erfindung kann aus der Figuren nicht gewonnen werden, da keine von ihnen dem eigentlichen Vorgehen entspricht, das in der Ausführungsform der Erfindung angeführt ist: Figuren 1 bis 4 zeigen gaussförmige Kurven, die die Wahrscheinlichkeitsdichte der Phase entsprechen; Figur 5 darstellt die bekannten Formeln für das Kalman-Filter; und Figur 6 zeigt als Beispiel, das mit dem Kalman-Filter der Erfindung ermittelte zeitliche Verlauf der Geswindigkeitskomponente, in Abhängigkeit von simulierten Zählimpulse, sowie der jeweiligen Varianz der Geschwindigkeit.Folglich ist eine<br>-/-- | |
| Recherchenort<br>Den Haag | Abschlußdatum<br>25. Januar 2010 | Prüfer<br>De La Pinta, Luis |

Europäisches
Patentamt

European
Patent Office

Office européen
des brevets

## ERKLÄRUNG

die nach Regel 63 des Europäischen Patentübereinkommens für das weitere Verfahren als
europäischer Recherchenbericht gilt

Nummer der Anmeldung

EP 09 16 9736

| Die Recherchenabteilung ist der Auffassung, daß die vorliegende Patentanmeldung den Vorschriften des EPÜ in einem solchen Umfang nicht entspricht, daß sinnvolle Ermittlungen über den Stand der Technik auf der Grundlage aller Patentansprüche nicht möglich sind.<br><br>Grund:<br><br>sinnvolle Recherche unmöglich. Der Anmelder wird darauf hingewiesen, dass im Zuge der Prüfung eine Recherche durchgeführt werden kann, sollten die einer Erklärung gemäss Regel 63 EPÜ zugrundeliegenden Mängel behoben worden sein (Vgl. EPA-Richtlinien C-VI, 8.2). | **KLASSIFIKATION DER ANMELDUNG** (IPC) |
|---|---|

| Recherchenort | Abschlußdatum | Prüfer |
|---|---|---|
| Den Haag | 25. Januar 2010 | De La Pinta, Luis |

EPO FORM 1504 (P04F39)